# EUROPÄISCHE PATENTSCHRIFT

(11) **EP 1 097 463 B1**
(45) Veröffentlichungstag und Bekanntmachung des Hinweises auf die Patenterteilung: **27.11.2002**
(21) Anmeldenummer: 99944235.3
(22) Anmeldetag: 01.07.1999
(51) Int. Cl.: H01F 1/37, H05K 9/00

(54) **MAGNETISIERBARES ERZEUGNIS, SEINE VERWENDUNG SOWIE EIN VERFAHREN ZU SEINER HERSTELLUNG**
MAGNETIZABLE PRODUCT, THE USE THEREOF AND A METHOD FOR PRODUCING THE SAME
PRODUIT MAGNETISABLE, SON UTILISATION ET SON PROCEDE DE PRODUCTION

(30) Priorität: 10.07.1998 DE 19830965
(43) Veröffentlichungstag der Anmeldung: 09.05.2001
(73) Patentinhaber: EPCOS AG, 81541 München (DE)
(72) Erfinder: ESGUERRA, Mauricio, D-82024 Taufkirchen (DE); LUCKE, Ralph, D-83714 Miesbach (DE)
(74) Vertreter: Epping, Wilhelm, Dipl.-Ing.
(86) Internationale Anmeldenummer: DE9901950
(87) Internationale Veröffentlichungsnummer: WO00003404

(56) Entgegenhaltungen:
- EP-A- 0 394 020
- EP-A- 0 785 557
- WO-A-92/08678

## Beschreibung

Die Erfindung betrifft ein magnetisierbares Erzeugnis, seine Verwendung sowie ein Verfahren zu seiner Herstellung.

Die Erfindung geht aus von der WO 92/08678 A1, aus welcher ein magnetisierbares Erzeugnis hervorgeht, welches durch Verfestigung einer Wasser und Zement enthaltenden formbaren Masse erhalten wird. Unter "Zement" wird hier ein mehr oder weniger komplexes Gemisch aus einem hydraulischen Zement im eigentlichen Sinne wie einem Portland-Zement, einem inerten Füllstoff wie feinkörniges Siliziumoxid, Flugasche, Kalk oder gemahlene Schlacke sowie ggf. einem oberflächenaktiven Mittel verstanden. Derartige Zemente sind als fertige Zubereitungen im Handel erhältlich und werden insbesondere von der Aalborg Portland A/S, Aalborg, Dänemark, Anmelderin der WO 92/08678 A1, hergestellt. Die formbare Masse enthält außerdem ein körniges magnetisches Material, insbesondere körniges Weicheisen. Aus dieser Formmasse kann beispielsweise ein Bauteil für eine dynamoelektrische Maschine als magnetisierbares Erzeugnis hergestellt werden.

Die Erfindung geht weiterhin aus von der EP 0 393 599 B1. Aus dieser geht eine oberflächenmontierbare elektrische Spule hervor, welche umhüllt ist von einem Erzeugnis aus Kunststoff, in welchen ein pulvriges magnetisches Material, insbesondere Carbonyleisen oder Ferrit, eingelagert ist.

Ferromagnetisches Material, beispielsweise Ferrit, hat als eine wesentliche Bestimmungsgröße die sog. Anfangspermeabilität, d.h. diejenige Permeabilität, welche das Material unter dem Einfluß eines nahezu verschwindenden magnetischen Feldes zeigt. Die Anfangspermeabilität eines Ferrit enthaltenden Festkörpers ist abhängig davon, mit welcher Korngröße der Ferrit vorliegt, wobei ein Verhältnis zwischen der Korngröße und einem typischen Domänendurchmesser in dem Ferrit von Bedeutung ist. Eine Domäne bezeichnet vorliegend einen Bereich mit homogener magnetischer Polarisation, wie er in jedem Ferromagneten auftritt. In einem üblichen Ferrit beträgt dieser typische Domänendurchmesser etwa 0,5 µm, und es hat sich gezeigt, daß die Anfangspermeabilität eines Festkörpers aus einem Ferrit stark reduziert ist, wenn der Korndurchmesser des Ferrits, d.h. der mittlere Durchmesser der Kristallite oder Körner in dem Ferrit, sich dem typischen Domänendurchmesser annähert. Als Grund dafür wird angesehen, daß bei fortschreitender Verringerung des Korndurchmessers hin zum typischen Domänendurchmesser die Anzahl der Domänen pro Korn drastisch sinkt, so daß der Prozeß der Verschiebung von Grenzen von Domänen als Reaktion auf eine makroskopische Magnetisierung des Festkörpers wegfällt. Es verbleibt allein der Prozeß der Rotation der Polarisierung innerhalb einer Domäne, welche allerdings nur eine geringe Permeabilität bedingt.

Dementsprechend ist es die Aufgabe der Erfindung, ein magnetisierbares Erzeugnis der eingangs definierten Art anzugeben, welches sich auszeichnet durch eine möglichst hohe Anfangspermeabilität. Das Erzeugnis soll sich auch durch gute Eigenschaften in dem für Zwecke der Informations- und Kommunikationstechnologie wichtigen Frequenzbereich oberhalb von 100 kHz, insbesondere zwischen 1 MHz und 2 GHz, auszeichnen. Es ist auch eine Aufgabe der Erfindung, eine Verwendung eines solchen Erzeugnisses sowie ein Verfahren zu seiner Herstellung anzugeben.

Zur Lösung dieser Aufgabe im Hinblick auf ein Erzeugnis angegeben wird ein magnetisierbares Erzeugnis, enhaltend Körner aus einem Ferrit, deren jedes Korn einen minimalen Durchmesser aufweist, welcher wesentlich größer als ein typischer Domänendurchmesser des Ferrits ist, welche Körner in eine feste Matrix eingebettet sind.

Dadurch, daß erfindungsgemäß Körner des Ferrits eingesetzt werden, welche relativ groß im Vergleich zum typischen Domänendurchmesser des verwendeten Ferrits sind, wird eine hohe Anfangspermeabilität gesichert, da die dazu notwendige Beweglichkeit der Domänengrenzen gewährleistet ist.

Es zeigt sich im Material des Erzeugnisses eine deutliche Dispersion bei einer Frequenz von etwa 100 MHz, welche sich darin äußert, daß in der Abschirmung deutliche Magnetisierungsverluste auftreten. Deshalb ist die Abschirmung beim Einsatz in einem entsprechenden Frequenzbereich, welcher für die Praxis der Informations- und Kommunikationstechnologie äußerst interessant ist, besonders wirkungsvoll.

Eine bevorzugte Ausgestaltung des Erzeugnisses zeichnet sich dadurch aus, daß die Matrix einen verfestigten Zement enthält. Ein solches Erzeugnis kann demnach hergestellt werden aus einer formbaren Masse gebildet aus Zement, Ferrit und Wasser. Durch geeignete Auswahl des Zements kann eine hohe Fließfähigkeit der formbaren Masse und damit ihre Eignung für ein druckloses Gießverfahren zur Formung gewährleistet werden. Eine solche formbare Masse ist besonders geeignet zum Vergießen eines elektrischen Bauelements wie einer Spule, wobei eine enge Maßtoleranz eingehalten werden müßte. Auch kann aus einer solchen formbaren Masse durch einfaches Vergießen eine Abschirmung für ein Kabel oder dergl. hergestellt werden. Eine solche formbare Masse ist auch geeignet, um als abschirmender Verputz auf eine Wand eines Gebäudes aufgetragen zu werden.

In dem Erzeugnis ist der Ferrit vorzugsweise mit einem Gewichtsanteil von mehr als 80 %, insbesondere zwischen 90 % und 95 %, vorhanden. Dazu wird zweckmäßig ein Spezialzement verwendet, welcher eine hohe Fließfä-higkeit der formbaren Masse durch einen Anteil einer entsprechenden oberflächenaktiven Substanz gewährleistet. Auch ist es von Vorteil, einen Zement zu verwenden, welcher nur relativ wenig Wasser für die Bildung der formbaren Masse erfordert; als zusätzliche Vorteile ergeben sich vergleichsweise geringer Schwund beim Austrocknen und weitgehende Freiheit von Poren, wie sie von überschüssigem Wasser gebildet werden können.

Eine besonders bevorzugte Ausbildung des Erzeugnisses zeichnet sich dadurch aus, daß der minimale Durchmesser jedes Korns des Ferrites zumindest 10 µm beträgt. Weiterhin bevorzugt ist es, daß ein mittlerer Durchmesser der Gesamtheit der Körner des Ferrits oberhalb von 100 µm liegt; als besonders zweckmäßig hat sich die Verwendung eines Ferrits erwiesen, bei dem die Gesamtheit der Körner besteht aus einer ersten Fraktion mit einem mittleren Durchmesser von etwa 8 mm und einer zweiten Fraktion mit einem mittleren Durchmesser von etwa 2 mm; die Durchmesser der einzelnen Körper beider Fraktionen dürfen dabei durchaus in einem jeweiligen weiten Bereich um den jeweiligen Mittelwert schwanken.

Das Erzeugnis ist vorzugsweise bestimmt zum Führen eines elektromagnetischen Feldes mit einer Frequenz zwischen 100 MHz und 10 GHz. Das Erzeugnis ist dazu insbesondere ausgebildet als Verputz auf einer Wand eines Gebäudes oder als Hülle für eine elektromagnetische Baugruppe. Diese Baugruppe kann ein komplettes elektromagnetisches Gerät oder auch nur eine Spule oder Leitung sein.

Zur Lösung der Aufgabe im Hinblick auf eine Verwendung wird erfindungsgemäß angegeben die Verwendung des vorstehend beschriebenen Erzeugnisses zum Führen eines elektromagnetischen Feldes mit einer Frequenz zwischen 100 MHz und 10 GHz. Dabei erfüllt das Erzeugnis insbesondere die Funktion einer Abschirmung.

Zur Lösung der auf ein Verfahren bezogenen Aufgabe wird erfindungsgemäß angegeben ein Verfahren zur Herstellung eines magnetisierbaren Erzeugnisses enthaltend Körner aus einem Ferrit, deren jedes Korn einen minimalen Durchmesser aufweist, welcher wesentlich größer als ein typischer Domänendurchmesser des Ferrits ist, welche Körner in eine feste Matrix eingebettet sind, insbesondere wie vorstehend dargestellt, welches Verfahren folgende Schritte umfaßt:
Bereitstellen des Ferrits als grobstückiges gesintertes Material, insbesondere Schrott;
Brechen des grobstückigen Materials und Aussondern geeigneter Körner des Ferrits;
Einbetten der Körner in eine formbare Masse; und
Formen und Aushärten der Masse zur Bildung der festen Matrix.

Dieses Verfahren geht aus von der Erkenntnis, daß zum Erhalt der notwendigen körnigen Zubereitung von Ferrit grobstückiges Material, wie es als Schrott bei der großtechnischen Herstellung herkömmlicher Bauteile aus Ferrit oder beim Recycling elektromagnetischer Geräte anfällt, verwertet werden kann. Das grobstückige Material braucht lediglich durch eine geeignete grobe Zerkleinerung in die gewünschte Körnung gebracht zu werden, insbesondere durch Brechen und Aussondern geeigneter Körner.

Wie bereits ausgeführt, kommt als formbare Masse vorzugsweise ein Gemisch aus Zement und Wasser zum Einsatz. Dabei kommen vorzugsweise 5 Gewichtsanteile Zement und 5 Gewichtsanteile Wasser auf 100 Gewichtsanteile Ferrit.

Ausführungsbeispiele der Erfindung werden nunmehr anhand der Zeichnung erläutert. Darin zeigen:
- Figur 1: einen Schnitt durch eine mit einem magnetisierbaren Erzeugnis in Form einer Abschirmung verputzte Wand;
- Figur 2: eine vergrößerte Teilansicht aus Figur 1;
- Figur 3 und Figur 4: eine Ansicht bzw. einen Schnitt durch ein magnetisierbares Erzeugnis in Form eines Schalenkerns;
- Figur 5 und Figur 6: jeweils ein Diagramm betreffend zumindest eine Materialkenngröße eines entsprechenden Erzeugnisses.

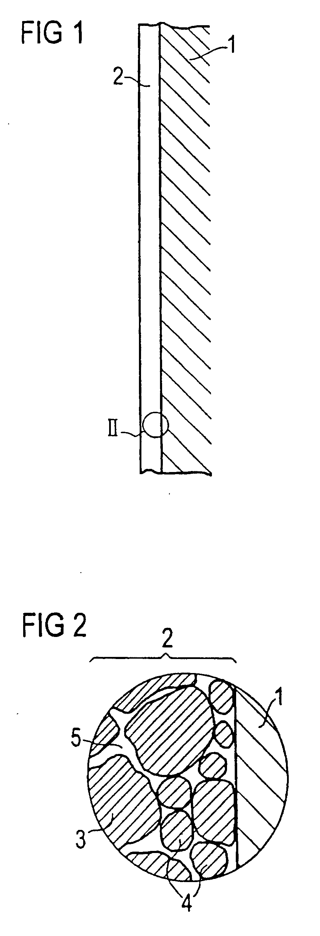

Figur 1 und Figur 2 zeigen einen Querschnitt durch eine Wand 1, welche mit einem magnetisierbaren Erzeugnis 2 in Form einer Abschirmung 2 zum Abschirmen einer elektromagnetischen Strahlung bzw. zum Abschirmen gegen ein elektromagnetisches Feld mit einer Frequenz oberhalb von 100 kHz verputzt ist. Die Wand 1 ist ausgeführt als gemauertes oder gegossenes Teil entsprechend herkömmlicher Praxis, die als Verputz 2 ausgebildete Abschirmung enthält Körner 3 und 4 aus einem Ferrit, eingebettet in eine feste Matrix 5 aus einem verfestigten Zement. Von Bedeutung ist, daß die Körner 3 und 4 wesentlich größer sind hinsichtlich ihrer minimalen Durchmesser als ein typischer Domänendurchmesser des Ferrits, welcher Domänendurchmesser üblicherweise bei etwa 0,5 µm liegt. Auf diese Weise ist eine relativ hohe Anfangspermeabilität der Abschirmung 2 gesichert. Die Größe der Körner 3 und 4 kann bis zu 10 mm betragen und demgemäß die Abschirmung 2 deutlich inhomogen erscheinen lassen; dies.ist für die wunschgemäße Funktion allerdings unter Umständen wesentlich, wie bereits erwähnt. Die Abschirmung 2 enthält eine erste Fraktion von Körnern 3 und eine zweite Fraktion von Körnern 4; die Gesamtheit der ersten Fraktion hat einen mittleren minimalen Durchmesser von etwa 8 mm, die zweite Fraktion einen mittleren minimalen Durchmesser der Gesamtheit der Körner 4 von etwa 2 mm. Die Streuung der minimalen Durchmesser der Körner 3 oder 4 beider Fraktionen kann vergleichsweise hoch sein, beispielsweise für die erste Fraktion zwischen 1 mm und 12 mm und für die zweite Fraktion zwischen 0,1 mm und 6 mm liegen. Als Zement zur Bildung der Matrix 5 dient ein von der Aalborg Portland A/S, Aalborg, Dänemark, beziehbares Handelsprodukt, welches seinerseits ein Gemisch aus einem Zement im eigentlichen Sinne und weiteren Bestandteilen, insbesondere einem feinkörnigen inerten Material wie Siliziumdioxid, Tonerde, Kalk und dergl. sowie einem oberflächenaktiven Mittel zur Erhöhung der Fließfähigkeit einer aus dem Zement hergestellten formbaren Masse ist. Von Bedeutung für die Auswahl des Zements ist, daß dieser zur Bildung einer angemessen fließfähigen Masse relativ wenig Wasser benötigen soll; auf diese Weise werden Poren in der festen Matrix 5 zuverlässig vermieden.

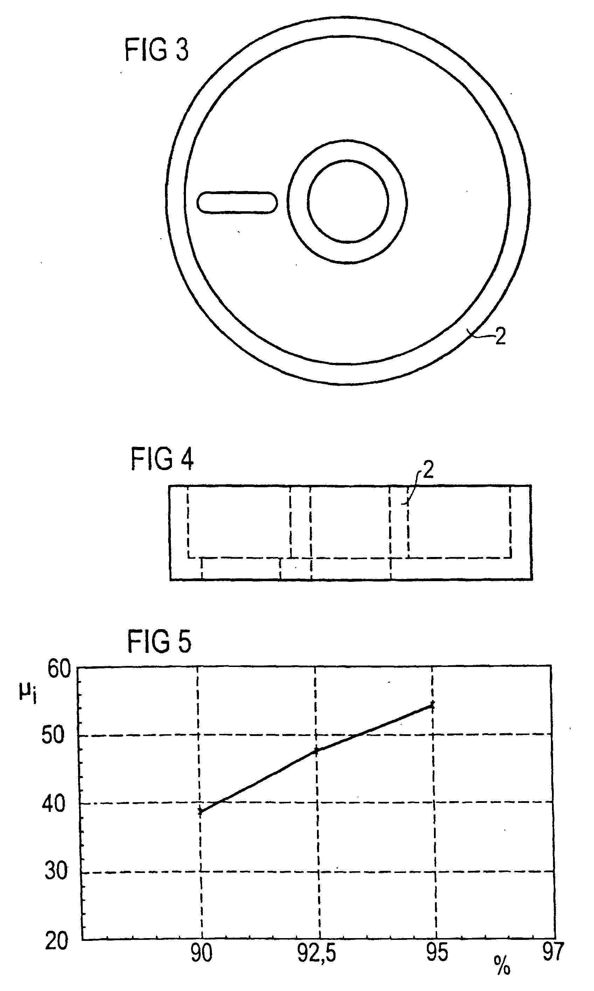

Die Figuren 3 und 4 zeigen eine Ansicht bzw. einen Querschnitt durch ein Erzeugnis 2 in Form eines Schalenkerns zur Führung eines elektromagnetischen Feldes mit einer Frequenz im angegebenen Bereich dient und aus demselben Material wie das aus den vorigen Figuren hervorgehende Erzeugnis 2 hergestellt ist.

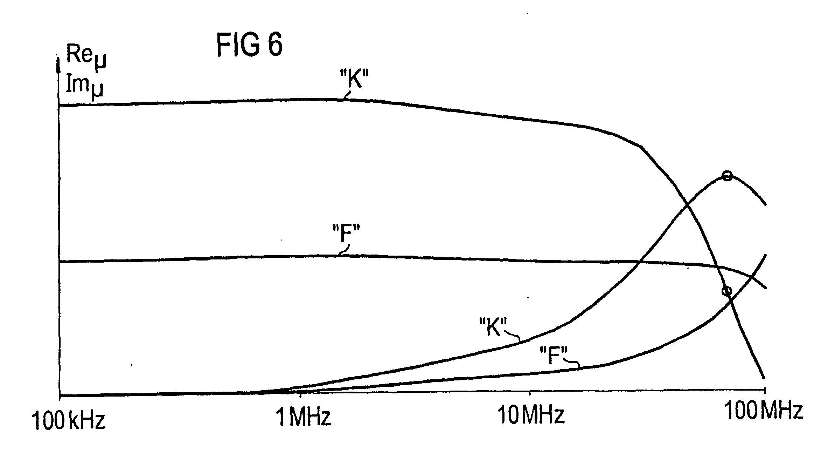

Figur 5 zeigt ein Diagramm, aus welchem die Anfangspermeabilität eines Erzeugnisses der dargestellten Art in Abhängigkeit vom Gewichtsanteil Ferrit in dem Erzeugnis hervorgeht. Die Zusammensetzung des Erzeugnisses entspricht weitgehend der anhand der vorigen Figuren erläuterten Zusammensetzung. Figur 6 zeigt die Abhängigkeit der Permeabilität von der Frequenz eines magnetischen Feldes, welches das Erzeugnis beaufschlagt. Dazu sei zunächst vermerkt, daß die Permeabilität im Grunde eine komplexwertige Größe ist, jedenfalls dann, wenn der Einfluß eines magnetischen Wechselfeldes betrachtet wird. Der Realteil der Permeabilität, wie er aufgetragen ist in Figur 5, beschreibt eine materialabhängige Proportionalität zwischen magnetischer Flußdichte B und magnetischer Erregung H. Der Imaginärteil der Permeabilität beschreibt eine Dämpfung, d.h. einen Energieverlust in dem einem magnetischen Wechselfeld ausgesetzten Material. Nimmt ein solcher Energieverlust eine wesentliche Höhe an, so spricht man von einer "Dispersion". Figur 6 zeigt die Abhängigkeit des Real- und Imaginärteils der Permeabilität zweier Erzeugnisse, die sich in ihrer Materialzusammensetzung leicht unterscheiden, von der Frequenz eines magnetischen Wechselfeldes, welches sie durchsetzt. Auf der Abszisse aufgetragen ist die Frequenz in logarithmischem Maßstab, auf der Ordinate aufgetragen die Permeabilität. Mit gleichen Buchstaben bezeichnete Kurven gehören dabei zusammen. Die außerhalb des Ursprungs des Diagramms jeweils beginnende Kurve beschreibt den Realteil der Permeabilität, die vom Ursprung des Diagramms jeweils ausgehende Kurve den Imaginärteil der Permeabilität. Man erkennt, daß bei niedriger Frequenz die Realteile praktisch konstant sind, während die Imaginärteile nahezu verschwinden. Bei Frequenzen deutlich oberhalb von 10 MHz stellt man wesentliche Abfälle der Realteile bei gleichzeitig wesentlichen Anstiegen der Imaginärteile fest; dies bedeutet, daß es in einem weiten Frequenzbereich um 100 MHz zum genannten Effekt der Dispersion kommt. Dies belegt die Wirksamkeit der mit einem entsprechenden Erzeugnis erreichbaren Abschirmung in einem weiten Frequenzbereich um 100 MHz, welcher für Zwecke der Information und Kommunikation hochinteressant ist, da in diesem Frequenzbereich sowohl der Frequenztakt eines üblichen Mikroprozessors als auch übliche Arbeitsfrequenzen für mobile Funkgeräte liegen. Die Erfindung ist somit zu Zwecken der Gewährleistung elektromagnetischer Verträglichkeit im Rahmen der Technologie der Information und Kommunikation von hoher Relevanz.

## Patentansprüche

1. Magnetisierbares Erzeugnis (2) enthaltend Körner (3, 4) aus einem Ferrit mit einem typischen Domänendurchmesser von etwa 0,5 µm, die in eine feste Matrix (5) eingebettet sind, wobei die Matrix ein verfestigter hydraulischer Zement ist, wobei die Ferrit-Körner (3, 4) bezüglich ihrer Größe aus zwei Fraktionen bestehen, wobei die erste Fraktion aus Körnern mit einem mittleren Durchmesser von 2mm bei einer Korngrößenverteilung zwischen 0,1 - 6mm und die zweite Fraktion aus Körnern mit einem mittleren Durchmesser von 8mm bei einer Korngrößenverteilung von 1 - 12mm besteht, und wobei der Ferrit mit einem Gewichtsanteil von mehr als 80 Prozent in dem Erzeugnis enthalten ist.

2. Erzeugnis (2) nach Anspruch 1,
welches bestimmt ist zum Führen eines magnetischen Feldes mit einer Frequenz zwischen 100 kHz und 10 GHz.

3. Erzeugnis (2) nach einem der vorherigen Ansprüche, welches als Verputz (2) auf einer Wand (1) eines Gebäudes ausgebildet ist.

4. Erzeugnis (2) nach einem der Ansprüche 1 oder 2,
welches als Hülle (2) für eine elektromagnetische Baugruppe ausgebildet ist.

5. Erzeugnis (2) nach Anspruch 4,
bei dem die Baugruppe ein elektromagnetisches Gerät, eine Spule oder eine Leitung ist.

6. Verwendung des Erzeugnisses nach einem der vorigen Ansprüche zum Führen eines elektromagnetischen Feldes mit einer Frequenz zwischen 100 kHz und 10 GHz.

7. Verfahren zur Herstellung eines magnetisierbaren Erzeugnisses (2) enthaltend Körner (3, 4) aus einem Ferrit, aus einem Ferrit mit einem typischen Domänendurchmesser von etwa 0,5 µm, die in eine feste Matrix (5) eingebettet sind, welches Verfahren folgende Schritte umfaßt:
Bereitstellen eines Ferrits als grobstückiges gesintertes Material, insbesondere Schrott;
Brechen des grobstückigen Materials und Aussondern einer ersten und zweiten Fraktion von Körnern (3, 4) des Ferrits, wobei die erste Fraktion aus Körnern mit einem mittleren Durchmesser von 2mm bei einer Korngrößenverteilung zwischen 0,1 - 6mm und die zweite Fraktion aus Körnern mit einem mittleren Durchmesser von 8mm bei einer Korngrößenverteilung von 1 - 12mm besteht
Einbetten der Körner (3, 4) in eine einen hydraulischen Zement und Wasser umfassende formbare Masse; sowie
Formen und Aushärten der Masse zu der Matrix (5), bei dem die formbare Masse gebildet wird aus 5 Gewichtsanteilen Zement und 5 Gewichtsanteilen Wasser bezogen auf 100 Gewichtsanteile Ferrit.

## Claims

1. Magnetizable product (2) containing grains (3, 4) of a ferrite with a typical domain diameter of approximately 0.5 µm, which are embedded in a solid matrix (5), the matrix being a set hydraulic cement, the ferrite grains (3, 4) comprising two fractions with respect to their size, the first fraction comprising grains with an average diameter of 2 mm with a grain size distribution between [sic] 0.1 - 6 mm and the second fraction comprising grains with an average diameter of 8 mm with a grain size distribution of 1 - 12 mm, and the ferrite being contained in the product with a proportion by weight of more than 80 per cent.

2. Product (2) according to Claim 1, which is intended for carrying a magnetic field with a frequency of between 100 kHz and 10 GHz.

3. Product (2) according to one of the preceding claims, which is formed as rendering (2) on a wall (1) of a building.

4. Product (2) according to either of Claims 1 and 2, which is formed as sheathing (2) for an electromagnetic subassembly.

5. Product (2) according to Claim 4, in which the subassembly is an electromagnetic device, a coil or a line.

6. Use of the product according to one of the preceding claims for carrying an electromagnetic field with a frequency of between 100 kHz and 10 GHz.

7. Method for producing a magnetizable product (2) containing grains (3, 4) of a ferrite, of a ferrite [sic] with a typical domain diameter of approximately 0.5 µm, which are embedded in a solid matrix (5), which method comprises the following steps:
preparing a ferrite as sintered material in large pieces, in particular scrap;
crushing the material in large pieces and sorting out a first and second fraction of grains (3, 4) of the ferrite, the first fraction comprising grains with an average diameter of 2 mm with a grain size distribution between [sic] 0.1 - 6 mm and the second fraction comprising grains with an average diameter of 8 mm with a grain size distribution of 1 - 12 mm;
embedding the grains (3, 4) in a mouldable composition comprising a hydraulic cement and water; and
moulding and curing the composition to form the matrix (5), in which the mouldable composition is formed from 5 parts by weight of cement and 5 parts by weight of water on the basis of 100 parts by weight of ferrite.

## Revendications

1. Produit (2) pouvant être magnétisé contenant des grains (3, 4) en un ferrite ayant un diamètre de domaine typique d'environ 0,5 µm, qui sont noyés dans une matrice (5) fixe, la matrice étant un ciment hydraulique durci, les grains (3, 4) de ferrite étant constitués de deux fractions relativement à leurs grandeurs, la première fraction étant constituée de grains ayant un diamètre moyen de 1 mm pour une répartition de grandeurs des grains comprises entre 0,1 et 6 mm et la deuxième fraction est constituée de grains ayant un diamètre moyen de 8 mm pour une répartition de grandeurs de grains de 1 à 12 mm, le ferrite étant contenu dans le produit en un rapport de poids supérieur à 80 %.

2. Produit (2) suivant la revendication 1, qui est destiné à guider un champ magnétique ayant une fréquence comprise entre 100 kHz et 10 GHz.

3. Produit (2) suivant l'une des revendications précédentes, qui est réalisé sous la forme d'un enduit (2) sur un mur (1) d'un bâtiment.

4. Produit (2) suivant l'une des revendications 1 ou 2, qui est réalisé en tant que gaine (2) pour un module électromagnétique.

5. Produit (2) suivant la revendication 4, dans lequel le module est un appareil électromagnétique, une bobine ou un conducteur.

6. Utilisation du produit suivant l'une des revendications précédentes pour guider un champ magnétique ayant une fréquence comprise entre 100 kHz et 10 GHz.

7. Procédé pour la fabrication d'un produit (2) pouvant être magnétisé contenant des grains (3, 4) en un ferrite ayant un diamètre de domaine typique d'environ 0,5 µm, grains qui sont noyés dans une matrice (5) fixe,
le procédé comportant les étapes suivantes :
préparation d'un ferrite sous la forme d'un matériau fritté en gros morceaux, notamment sous forme de grenaille,
fragmentation du matériau en gros morceaux et triage d'une première et d'une deuxième fractions des grains (3, 4) du ferrite, la première fraction étant constituée de grains ayant un diamètre moyen de 2 mm pour une répartition de grandeurs de grains comprises entre 0,1 et 6 mm et la deuxième fraction est constituée de grains ayant un diamètre moyen de 8 mm pour une répartition de grandeurs de grains comprises entre 1 et 12 mm,
incorporation des grains (3, 4) dans une masse moulable contenant un ciment hydraulique et de l'eau ; ainsi que
moulage et durcissement de la masse en la matrice (5), la masse moulable étant réalisée à partir de 5 parties en poids de ciment et de 5 parties en poids d'eau se rapportant à 100 parties en poids de ferrite.
